# EUROPÄISCHE PATENTSCHRIFT

(11) **EP 0 247 377 B1**
(45) Veröffentlichungstag und Bekanntmachung des Hinweises auf die Patenterteilung: **17.03.1993**
(21) Anmeldenummer: 87106227.9
(22) Anmeldetag: 29.04.1987
(51) Int. Cl.: H05K 7/08, G09F 9/33, G09F 13/22, H05K 1/00, H05K 1/18

(54) **Leiterplatte für Flächenanzeige**
Printed-circuit board for an indication board
Plaquette à circuit imprimé pour tableau d'indication

(30) Priorität: 30.05.1986 DE 3618285
(43) Veröffentlichungstag der Anmeldung: 02.12.1987
(73) Patentinhaber: LUMINO Licht Elektronik GmbH, D-47799 Krefeld (DE)
(72) Erfinder: Kemper, Rolf, D-4230 Wesel (DE)

(56) Entgegenhaltungen:
- FR-A- 2 339 922
- GB-A- 1 317 510
- ELEKTRONIK-INDUSTRIE Nr. 7/8, 1976, Seiten 162-163, München, D; W. FLEISCHHAUER; "Ansteuerungen von Leuchtdioden durch TTL-Bausteine"
- VDI-Berichte Nr. 519, 1984, S. 5-10, Düsseldorf, D. Horak; " SMD-Technologie und ihre technischen und wirtschaftlichen Auswirkungen"

## Beschreibung

Die Erfindung betrifft eine Leiterplatte für eine Flächenanzeige, insbesondere eine Leiterplatte für eine Anzeigetafel zu Informations- und Darstellungszwecken nach dem Oberbegriff des Patentanspruchs 1.

Leiterplatten der vorgenannten Art gehören zum allgemeinen Stand der Technik und werden beispielsweise in der Praxis eingesetzt, um Leuchtlaufschriften darzustellen. Ein solches Leuchtlaufschriftsystem besteht im wesentlichen aus einer Anzeigetafel mit automatischer Programmspeicherung, einer anschließbaren Tastatur zum Zweck der Eingabe von Texten und Grafiken und aus einem einsteckbaren Modul zur externen Programmspeicherung bei Programmaustausch. Die Anzeigetafel ist dabei in der Regel eine mikroprozessorgesteuerte LED-Leuchtfeldfläche, auf der eine Vielzahl von Leuchtdioden in einem vorgegebenen Raster montiert sind. Über die Mikroprozessoren werden die einzelnen Leuchtdioden (LED) angesteuert, wobei von den Mikroprozessoren der Befehl ausgegeben wird, ob und wie lange jede einzelne LED aufleuchten soll. Wegen der sehr großen Menge von LED's wird die Layoutgestaltung einer Leiterplatte speziell bei Flächenanzeigen kompliziert und aufwendig.

So ist es bekannt, für Platinen mit hoher Bauteildichte in der Regel Leiterplatten mit doppelseitiger Leiterbahnführung und mit entsprechenden Durchkontaktierungen zu verwenden. In Fällen noch größerer Bauteildichte und kleineren Flächen sind sogar mehrlagige Leiterplatten erforderlich. Daraus folgt zwangsläufig eine geringe Leiterbahnbreite, was zu einer aufwendigen Herstellung und zu hohen Produktionskosten für solche Leiterplatten führt.

In den Displayanwendungen sind außerdem relativ große Flächen notwendig, die möglichst robust aufgebaut werden müssen, um allen Anforderungen während des Einsatzes gerecht zu werden.

Aus der FR-A-2 339 922 ist eine Signaleinrichtung bekannt, bei der eine Leiterplatte mit Leuchtdioden in einem vorgegebenen Raster bestückt ist. Die Anschlußpins der LED's ragen aus der Rückseite der Leiterplatte heraus, wo sie mit einem Isolierschutz abgedeckt sind.

Die GB-A-1 317 510 offenbart Verbesserungen in bezug auf die Leiterplatten mit ihren Leiterbahnführungen bei einem Rechner. Dabei wird insbesondere die Verbesserung der Layoutgestaltung vorgestellt, bei der kurze Leiterbahnführungen zwischen den Bauelementen angestrebt werden. Ein besonderes Rechenprogramm unterstützt den Fachmann darin, durch geschickte Leiterbahnführungen Zu einem hohen Grad einer Verbindungsdichte zu kommen.

Ausgehend von dem geschilderten Stand der Technik ist es Aufgabe der Erfindung, eine Leiterplatte für Flächenanzeigen der eingangs genannten Art zu schaffen, bei welcher die Leiterbahnführung zwischen den Bauelementen weiter vereinfacht und der Aufwand zur Layoutgestaltung bei angehobener Funktionalität verringert werden.

Diese Aufgabe wird erfindungsgemäß mit den Merkmalen des Kennzeichenteils von Patentanspruch 1 gelöst. Weiterbildungen und besondere Ausgestaltungen sind den Unteransprüchen zu entnehmen, wobei eine besondere Ausführung vorsieht, jeweils Gruppen von wahlweise zwei oder/und mehr in beliebiger Geometrie zueinander angeordnete LED's immer gleich durch Leiterbahnen mit den Treiberbausteinen zu verbinden. So kann beispielsweise durch eine Gruppe im Kreis angeordneter Leuchtdioden eine Analoguhr darstellbar sein.

Die aufgabengemäße Vereinfachung des Leiterbahnbildes wird durch die Merkmale der Patentansprüche in einfacher und sicherer Weise erreicht. Der Erfindung liegt dabei die Grundüberlegung zugrunde, daß jeder Leuchtpunkt in einem Display üblicherweise von einem Treiberbaustein angesteuert wird, der über eine feste Zuordnung seiner Ausgänge zum Ansteuersignal für die LED's verfügt. Im Falle eines Schieberegisters wird mit jedem Takt ein neues Datenbit eingelesen. Nach der Länge des Schieberegisters entsprechenden Anzahl von Takten ist also Bit n am Ausgang n Bit n minus 1 am Ausgang n minus 1. Weiterhin sind die vom Ansteuersystem ausgegebenen Daten fast immer linear adressiert. Demzufolge müßte auch die Verdrahtung einer Platine der linearen Adressierung entsprechen. Da jedoch die mechanische Lage der Anschlußpins des Treiberbausteins fast nie direkt an den zugeordneten Leuchtpunkt gelegt werden kann, ergibt sich eine sehr komplizierte Leiterbahnführung mit allen ihren technischen Nachteilen.

Wenn man nun entsprechend den Erfindungsmerkmalen an einen Ausgang jeweils den nächstliegenden Leuchtpunkt anschließt, so ergibt sich ein wesentlich vereinfachtes Leiterbahnbild, welches eine wesentlich vereinfachte Herstellung zuläßt. Die sich durch diese erfindungsgemäße Zuordnung ergebende Verwürfelung der Zuordnung kann nun erfaßt und vom Ansteuersystem aufgehoben werden.

Wenn ein DIL-Gehäuse auf eine Fläche gelegt wird, so ergibt sich infolge der Anschlußpins ein relativ großer Abstand zwischen dem Gehäuseboden und der Leiterbahnfläche. Dieser Abstand reicht aus, um die Anschlußpins anderer Bauteile unterzubringen. In der Anwendung in einem Flächendisplay hat diese Eigenschaft eine große Bedeutung. Für die Anschlüsse des Treiberbausteines sind jetzt nur noch zwei Reihen von Lötpunkten notwendig, die jedoch keine Bohrlöcher mehr enthalten. Damit ist es möglich geworden, durch zweiseitige Bestückung auch dort Leuchtdioden unterzubringen, wo die Treiberbaustein-Gehäuse sitzen.

In der Zeichnung ist ein Beispiel der Erfindung dargestellt. Darin zeigen
- Fig. 1: die erfindungsgemäße Leiterplatte im Schnitt mit der Darstellung eines Treiberbausteines und den Leuchtdioden
- Fig. 2: die Leiterplatte gemäß Fig. 1 im Schnitt, wiederum mit der Darstellung von Leuchtdioden und des Treiberbausteines aus der Richtung des Pfeiles II in Fig. 1
- Fig. 3: eine erfindungsgemäße Leiterplatte nach den Fig. 1 und 2 in der Draufsicht.

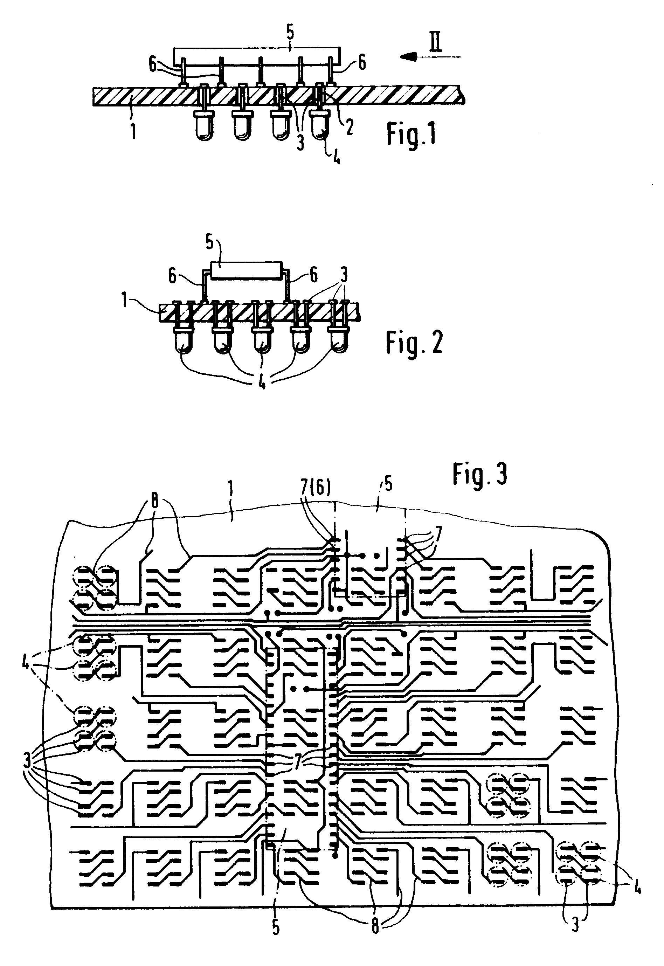

Die Leiterplatte 1 für eine Flächenanzeige bzw. für eine Anzeigetafel zu Informations- und Darstellungszwecken besitzt in einem vorgegebenen Raster Bohrungen 2, durch welche die Anschlußbeinchen 3 von Leuchtdioden 4 hindurchgesteckt sind. Auf der den Leuchtdioden 4 gegenüberliegenden Seite der Leiterplatte 1 sind Treiberbzw. Steuerbausteine 5 im Abstand über der Leiterplattenoberfläche angeordnet. Die Anschlußpins 6 der Steuer- oder Treiberbausteine 5 stehen dabei auf der Leiterplattenoberfläche auf und sind mit der Leiterplatte 1 durch zwei parallele Reihen von Lötpunkten 7 elektrisch und mechanisch angeschlossen. Wie insbesondere aus den Figuren 1 und 2 ersichtlich ist, sind die Leuchtdioden 4 durchgehend auch unterhalb der Steuer- oder Treiberbausteine 5 angeordnet.

Die Anschlußbeinchen 3 der Leuchtdioden 4 sind nun über Leiterbahnen 8 mit den Anschlußpins 6 der Steuer- oder Treiberbausteine 5 elektrisch verbunden. Das erfindungsgemäße Leiterbahnbild zeigt dabei deutlich vor allem Figur 3. Von entscheidender Bedeutung bei dieser Erfindung ist es, daß immer die nächstgelegenen Anschlußbeinchen 3 von Leuchtdioden 4 mit den Anschlußpins 6 der Treiberbausteine 5 verbunden werden. Dies erfolgt völlig ohne Beachtung der in den Treiberbausteinen 5 innewohnenden Anordnung der Treiberausgänge. Dadurch werden die Leiterbahnen im Regelfall relativ kurz und ohne komplizierte Führung ausgeführt. Vor allen Dingen entfällt die üblicherweise bei solch hohen Packungsdichten erforderliche Durchkontaktierung.

Die sich aus der vereinfachten Leiterbahnführung ergebende Verwürfelung der Zuordnung von Anschlußbeinchen 3 zu Anschlußpins 6 der Treiberbausteine 5 wird erfaßt und von dem Ansteuersystem aufgehoben. Dies bedeutet, daß eine Meßwertkorrelation eingesetzt ist, die nach Art einer Meßwerttabelle arbeitet und erkennt, daß beispielsweise bei einem Befehl des Treiberbausteines 5 für einen Anschluß einer beliebigen Leuchtdiode (X) der Speicher erkennt, daß dies für die tatsächlich vorgenommene Anordnung eine bestimmte Leuchtdiode (Y) ist.

Eine Leiterplatte 1 einer Informationsanzeige beispielsweise ist mit Gruppen von jeweils vier Leuchtdioden 4 im Viereck bestückt. Hier sind natürlich auch andere geometrische Formationen mit der entsprechenden Menge von Leuchtdioden 4 möglich. Die Anschlußbeinchen 3 der Leuchtdioden 4 sind durch die jeweils vier Paare von Bohrungen hindurchgesteckt und auf der Rückseite der Leiterplatte mechanisch und elektrisch verbunden mit Leiterbahnen 8, die zu Anschlußpunkten des Treiberbausteines (IC-Baustein) 5 führen. Insgesamt sind an einen Treiberbaustein 5 auf diese Weise insgesamt vierzig Leuchtdioden 4 angeschlossen. Die Anschlußpunkte 7 für den Treiberbaustein 5 befinden sich in zwei zueinander parallelen Reihen zwischen den Anschlußpunkten der Leuchtdioden 4. Der Treiberbaustein 5 erhebt sich über den Leiterbahnen 8 und allen Anschlußpunkten bzw. Lötpunkten, so daß die geometrische Anordnung durchgehend eingehalten wird.

Die sinnvolle Leiterbahnführung erlaubt relativ breite Leiterbahnen 8, wodurch mögliche Fehler und Unterbrechungen, wie sie bei oftmals sehr schmalen Leiterbahnen vorkommen, vermieden werden.

Die jeweils vier Leuchtdioden einer Gruppe sind im Beispiel der Figur 3 durchgeschaltet und mit einer kurzen Leiterbahn 8 zum Treiberbaustein 5 verbunden.

Sämtliche in den Figuren dargestellten und in der Beschreibung erläuterten Einzelheiten sind für die Erfindung wichtig.

## Patentansprüche

1. Leiterplatte (1) und Ansteuerschaltung für Flächenanzeige, insbesondere Leiterplatte(1) für eine Anzeigetafel zu Informations- und Darstellungszwecken, mit im vorgegebenen Raster bestückten Leuchtdioden (4), die mittels Leiterbahnen (8) an Treiber- oder Steuerbausteine (5) elektrisch angeschlossen sind,
dadurch gekennzeichnet,
daß an die Anschlußpins (6) der Treiber- oder Steuerbausteine (5) ohne Berücksichtigung der üblicherweise festen Zuordnung der Ausgänge zum Ansteuersignal für die Leuchtdioden (4) jeweils die örtlich auf der Leiterplatte (1) nächstliegende Leuchtdiode (4) auf direktem, kreuzungsfreiem Weg elektrisch und mechanisch angeschlossen ist, wobei die feste Zuordnung der Ausgänge der Treiber- oder Steuerbausteine (5) durch Erfassen der zufallsbedingten Zuordnung der Ausgänge zu den Leuchtdioden (4) in einer Ansteuerschaltung aufgehoben ist.

2. Leiterplatte (1) und Ansteuerschaltung nach Anspruch 1,
dadurch gekennzeichnet,
daß die Steuer- oder Treiberbausteine (5) mittels zwei Reihen von Lötpunkten (7) auf der Seite der aufgetragenen Leiterbahnen (8) mit der Leiterplatte (1) mechanisch und elektrisch verbunden sind, wobei die Steuer- oder Treiberbausteine (5) im Abstand über der Leiterplatte (1) vorgesehen sind, und daß die Leuchtdioden (4) auf der den Steuer- oder Treiberbausteinen (5) gegenüberliegenden Seite der Leiterplatte (1) mit durch Bohrungen (2) hindurchgesteckten Anschlußbeinchen (3) in einem über die gesamte Leiterplatte (1) und unter den Steuer- oder Treiberbausteinen (5) durchgehenden Raster mit den Anschlußpins (6) der Treiber- oder Steuerbausteine (5) durch Leiterbahnen (8) mechanisch und elektrisch verbunden sind.

3. Leiterplatte und Ansteuerschaltung nach den Ansprüchen 1 und/oder 2,
dadurch gekennzeichnet,
daß jeweils Gruppen von vier im Rechteck zueinander angeordnete Leuchtdioden (4) im sogenannten Viererblock durch immer gleiche Leiterbahnführung mit den Steuer-oder Treiberbausteinen (5) verbunden sind, ohne die den Steuer- oder Treiberbausteinen (5) innewohnende Schaltungsanordnung zu berücksichtigen, welche durch Meßwertkorrelation aufgehoben ist.

4. Leiterplatte und Ansteuerschaltung nach den Ansprüchen 1 und/oder 2,
dadurch gekennzeichnet,
daß jeweils Gruppen von wahlweise zwei und/oder mehr in beliebiger Geometrie zueinander angeordnete Leuchtdioden (4) immer gleich mit den Steuer- oder Treiberbausteinen (5) verbunden sind.

5. Leiterplatte und Ansteuerschaltung nach den Ansprüchen 1 bis 3,
dadurch gekennzeichnet,
daß jeweils mehrere Leuchtdioden (4) für einen Leuchtpunkt vorgesehen sind.

## Claims

1. A printed circuit board (1) and actuation circuit for a surface display, in particular a printed circuit board (1) for a display panel for information and representation purposes, comprising light emitting diodes (4) which are fitted in the predetermined pattern and which are electrically connected to driver or control components (5) by means of conductor tracks (8),
characterised in that the respective light emitting diode (4) which is nearest in position on the printed circuit board is electrically and mechanically connected in a direct, intersection-free manner to each of the terminal pins (6) of the driver or control components (5), without having regards to the usually fixed association of the outputs with the actuation signal for the light emitting diodes (4), wherein the fixed association of the outputs of the driver or control components (5) is nullified by detection of the randomly governed association of the outputs with the light emitting diodes (4) in an actuation circuit.

2. A printed circuit board (1) and actuation circuit according to claim 1,
characterised in that the control or driver components (5) are mechanically and electrically connected to the printed circuit board (1) by means of two rows of solder points (7) on the side of the applied conductor tracks (8), wherein the control or driver components (5) are disposed at a spacing above the printed circuit board (1), and that the light emitting diodes (4), on the side of the printed circuit board (1) which is in opposite relationship to the control or driver components (5), with connecting leg portions (3) which are passed through bores (2), are mechanically and electrically connected by conductor tracks (8) to the terminal pins (6) of the driver or control components (5), in a pattern which extends over the entire printed circuit board (1) and under the control or driver components (5).

3. A printed circuit board and actuation circuit according to claims 1 and/or 2,
characterised in that respective groups of four light emitting diodes (4) which are disposed in a rectangle relative to each other are connected in a so-called block of four to the control or driver components (5) by a conductor track configuration which is always the same, without taking into consideration the circuit arrangement which is inherent in the control or driver components (5) and which is nullified by measurement value correlation.

4. A printed circuit board and actuation circuit according to claims 1 and/or 2,
characterised in that respective groups of selectively two and/or more light emitting diodes (4) which are associated with each other in any geometry are always connected in the same manner to the control or driver components (5).

5. A printed circuit board and actuation circuit according to claims 1 to 3,
characterised in that a plurality of light emitting diodes (4) are provided for a respective light point.

## Revendications

1. Plaque de circuits imprimés (1) et circuit de commande pour affichage, en particulier plaque de circuits imprimés (1) pour un panneau d'affichage d'informations et de représentation, comportant des diodes électroluminescentes (4), disposées suivant une grille donnée, lesquelles sont électriquement connectées, au moyen de tracés conducteurs (8), à des composants d'excitation ou de commande (5), caractérisée en ce que la diode électroluminescente (4) localement la plus proche sur la plaque de circuits imprimés (1), est reliée électriquement et mécaniquement, par voie directe et sans croisement, aux broches de branchement (6) des composants d'excitation et de commande (5), sans tenir compte de l'affectation fixe usuelle des sorties au signal de commande des diodes électroluminescentes (4), l'affectation fixe des sorties des composants d'excitation ou de commande (5) étant supprimée dans un circuit de commande, par enregistrement de l'affectation aléatoire des sorties aux diodes électroluminescentes (4).

2. Plaque de circuits imprimés (1) et circuit de commande selon la revendication 1, caractérisée en ce que les composants de commande ou d'excitation (5) sont mécaniquement et électriquement reliés à la plaque de circuits imprimés (1), au moyen de deux rangées de points de soudure (7), sur le côté des tracés conducteurs (8) appliqués, les composants de commande ou d'excitation (5) étant prévus espacés sur la plaque de circuits imprimés (1) et en ce que les diodes électroluminescentes (4), sur le côté opposé aux composants de commande ou d'excitation (5), de la plaque de circuits imprimés (1), sont reliées mécaniquement et électriquement, par des tracés conducteurs (8), avec des pattes de branchement (3), traversant des trous (2), dans une grille s'étendant sur toute la plaque de circuits imprimés (1) et sous les composants de commande ou d'excitation (5), avec les broches de branchement (6) des composants d'excitation ou de commande (5).

3. Plaque de circuits imprimés (1) et circuit de commande selon les revendications 1 et/ou 2, caractérisée en ce que des groupes de quatre diodes électroluminescentes (4), disposées entre elles en rectangle, dans ce qu'il est convenu d'appeler un quartet, sont reliés, par toujours le même tracé conducteur, avec les composants de commande ou d'excitation (5), sans tenir compte du montage inhérent aux composants de commande ou d'excitation (5) qui est supprimé par corrélation des valeurs mesurées.

4. Plaque de circuits imprimés (1) et circuit de commande selon les revendications 1 et/ou 2, caractérisée en ce que des groupes de deux et/ou plus, au choix, de diodes électroluminescentes (4), disposées les unes par rapport aux autres suivant une géométrie quelconque, sont reliés toujours de la même façon avec les composants de commande ou d'excitation (5).

5. Plaque de circuits imprimés (1) et circuit de commande selon les revendications 1 à 3, caractérisée en ce qu'il est prévu chaque fois plusieurs diodes électroluminescentes (4) pour un point lumineux.
